Europäisches Patentamt

European Patent Office

Office européen des brevets

(11) Veröffentlichungsnummer: **0 451 748 A2**

## EUROPÄISCHE PATENTANMELDUNG

(21) Anmeldenummer: 91105499.7

(22) Anmeldetag: 08.04.91

(51) Int. Cl.5: **H03G 3/20, H04B 10/14**

(30) Priorität: 10.04.90 DE 4011539

(43) Veröffentlichungstag der Anmeldung:
16.10.91 Patentblatt 91/42

(84) Benannte Vertragsstaaten:
BE CH DE FR IT LI NL SE

(71) Anmelder: Standard Elektrik Lorenz
Aktiengesellschaft
Lorenzstrasse 10
W-7000 Stuttgart 40(DE)
(84) DE

(71) Anmelder: ALCATEL N.V.
Strawinskylaan 341 (World Trade Center)
NL-1077 XX Amsterdam(NL)
(84) BE CH FR IT LI NL SE

(72) Erfinder: Benz, Paul
Schwärmerweg 7
W-7000 Stuttgart(DE)

(74) Vertreter: Pohl, Heribert, Dipl.-Ing et al
Standard Elektrik Lorenz AG Patent- und
Lizenzwesen Postfach 30 09 29
W-7000 Stuttgart 30(DE)

(54) Vorrichtung zum Empfang optischer Signale.

(57) Zur Erweiterung der Eingangsdynamik optischer Empfänger wird dem Eingang solcher Empfänger oft ein steuerbarer Widerstand parallel geschaltet. Dabei wird das Steuersignal für den steuerbaren Widerstand aus dem Ausgangssignal des Empfängers abgeleitet. Dadurch ist es mit den Übertragungseigenschaften des Emfängers behaftet. Erfindungsgemäß wird eine Lösung vorgeschlagen, die das Steuersignal für den steuerbaren Widerstand direkt aus dem von der Fotodiode gelieferten Strom ableitet.

FIG.3

Die Erfindung betrifft eine Vorrichtung zum Empfang optischer Signale, insbesondere eine Vorrichtung mit vergrößertem Dynamikbereich, wie sie beispielsweise aus der internationalen Patentanmeldung WO 86/01354 bekannt ist.

In der dort beschriebenen Schaltung eines optischen Empfängers wird ein von einer Fotodiode stammender Fotostrom einem Transimpedanzverstärker zugeführt. Parallel zum Eingang des Transimpedanzverstärkers liegt ein Shunt, der den Transimpedanzverstärker bei großen Fotoströmen, d.h. großen Eingangssignalen, vor Übersteuerung schützt. Bei diesem Shunt handelt es sich um einen steuerbaren Widerstand, beispielsweise einen als ohmschen Widerstand betriebenen Feldeffekttransistor (FET). Das Gate dieses FET ist über einen Peak-to-Peak-Detektor mit dem Ausgang des Transimpedanzverstärkers verbunden. Aus dem Ausgangssignal des Transimpedanzverstärkers wird also mit anderen Worten ein Signal abgeleitet, das den Widerstand des Shunt steuert. Bei Signalen, die den

Transimpedanzverstärker übersteuern könnten, wird der Widerstand des Shunt soweit vermindert, daß keine Übersteuerung eintritt.

Die bekannte Schaltung hat den Nachteil, daß das Steuersignal für den Shunt am Ausgang des Transimpedanzverstärkers gewonnen wird. Dadurch geht das Übertragungsverhalten des Transimpedanzverstärkers mit in den Regelkreis ein, was oft unerwünscht ist.

Aufgabe der Erfindung ist es, einen optischen Empfänger durch Regelung des Eingangsstromes so vor Übersteuerung zu schützen, daß sein eigenes Übertragungsverhalten nicht in den Regelkreis mit eingeht.

Gelöst wird diese Aufgabe durch eine Vorrichtung mit der Merkmalskombination des Hauptanspruches.

Die erfindungsgemaße Vorriohtung hat den Vorteil, Schaltungstechnisch einfach und kostengünstig zu sein. Die Unteransprüche enthalten vorteilhafte Ausgestaltungen der Erfindung.

Ein Ausführungsbeispiel der Erfindung wird nachfolgend anhand der Figuren 1 bis 4 beschrieben und erläutert. Es zeigen:

Fig. 1    das Prinzip der Dynamikerweiterung mit Hilfe eines Shunts,

Fig. 2    eine von der Fotodiode abgegebene Pulsfolge,

Fig. 3    ein Schaltungsbeispiel für die Realisierung eines gesteuerten Shunts,

Fig. 4    Schaltungsvariante nach Fig. 3 mit mitgeführtem $U_0$.

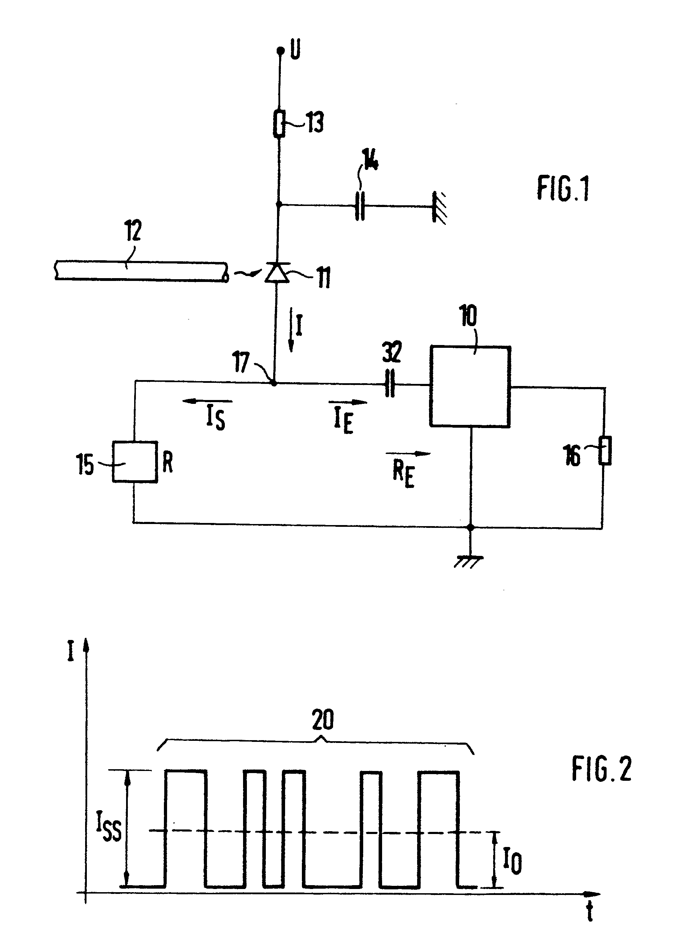

In Fig. 1 ist eine Vorrichtung zum Empfang optischer Signale dargestellt. Die optischen Signale stammen aus einem Lichtwellenleiter 12 und werden in einer Fotodiode 11, beispielsweise einer Pin-Diode, in elektrische Signale umgewandelt. Die Fotodiode 11 wirkt dabei wie eine Stromquelle, die einen mit I bezeichneten Strom abgibt. In einem mit 17 bezeichneten Knotenpunkt teilt sich der von der Diode erzeugte Strom I in einen Strom $I_E$ und einen Strom $I_S$ auf. Der Strom $I_E$ fließt in den Eingang eines mit 10 bezeichneten Empfängers. Um den Empfänger 10 bei zu großen Stromimpulsen vor überlastung zu schützen, ist ein mit 15 bezeichneter steuerbarer Widerstand vorgesehen, durch den der Strom $I_S$ fließt. Ein mit 16 bezeichneter Widerstand dient am Ausgang des Empfängers 10 als Lastwiderstand. Ein Kondensator 32 dient der gleichstrommäßigen Entkopplung von Fotodiode 11 und Empfänger 10. Mit 13 ist ein Widerstand bezeichnet, der zusammen mit einem Kondensator 14 die Fotodiode 11 von Störspannungen, die in der Betriebsspannungsquelle enthalten sein können, freihält. Der Kondensator 14 legt die Fotodiode 11 kathodenseitig auf Bezugspotential.

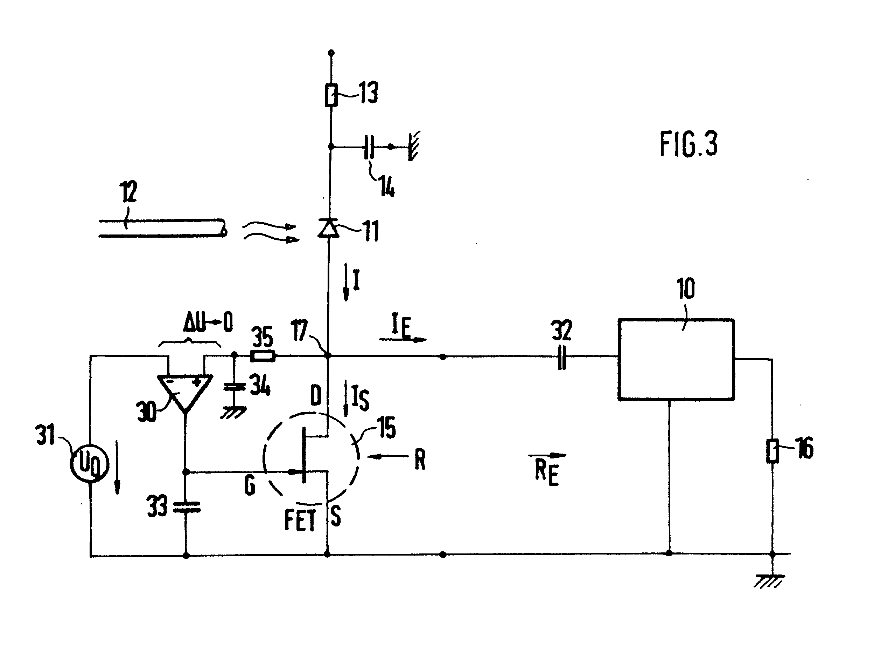

Fig. 2 zeigt einen Ausschnitt aus einer Folge von Strompulsen 20, wie sie von der Diode 11 abgegeben werden. $I_{SS}$ bezeichnet den Betrag des Stromes von Spitze zu Spitze, $I_0$ einen in der Pulsfolge enthaltenen Gleichstromwert. Dieser Gleichstromwert $I_0$ ist in der folgenden Betrachtung zu Fig. 3 von Bedeutung.

Im folgenden werden gleiche Bezugszeichen für die gleichen Elemente benutzt. Fig. 3 enthält die bereits aus Fig. 1 bekannten Elemente Lichtwellenleiter 12, Fotodiode 11, Widerstand 13, Kondensator 14, Empfänger 10, Lastwiderstand 16 und Knotenpunkt 17. Der mit 15 bezeichnete Shunt ist ein Feldeffekttransistor (FET). Sein Drainanschluß ist mit dem Knoten 17 verbunden, sein Sourceanschluß mit einem Bezugspotential, beispielsweise Masse. Knotenpunkt 17 ist über einen Widerstand 35 mit dem nicht invertierenden Eingang eines Operationsverstärkers 30 verbunden. Der nicht invertierende Eingang des Operationsverstärkers 30 liegt über einen Kondensator 34 auf Bezugspotential. Widerstand 35 und Kondensator 34 stellen eine RC-Kombination mit integrierender Wirkung dar, die den nicht invertierenden Eingang eines Operationsverstärkers 30 mit dem dem Gleichanteil der Impulsfolge 20 entsprechenden Signal versorgt. Diese RC-Kombination hat auch die Aufgabe, den Regelkreis hochohmig vom HF-Teil (Punkt 17) zu entkoppeln. Die Regelzeit wird durch dieses RC-Glied bestimmt. Der invertierende Eingang des Operationsverstärkers 30 wird auf einem festen, aber frei wählbaren Potential 31 gehalten. Das Potential 31 ($U_0$) kann auch vom Fotostrom mitgeführt werden und zwar derart, daß sich bei kleinen Lichtpegeln ein großes $U_0$ und bei großen Lichtpegeln ein kleines $U_0$ einstellt. Dies ergibt einen größeren Dynamikbereich. Der Ausgang des Operationsverstärkers 30 ist mit dem Gateanschluß des FET 15 verbunden. Diese Verbindung wird über einen Kondensator 33 auf Bezugspotential gelegt. Dadurch werden Störungen vom FET 15 ferngehalten. Auch wird die schädliche Rückwirkung der Gate-Drain-Kapazität unterdrückt. Man wählt den Kondensator 33 nicht zu groß. Die bestimmte Regelzeit soll ausschließlich durch R35 C34 bestimmt werden, um Regelschwingungen zu vermeiden.

Die beschriebene Schaltung arbeitet wie folgt. Im eingeschwungenen Zustand des Regelkreises stellt sich die Drain-Source-Spannung $U_{DS}$ und die Kondensatorspannung $U_{C34}$ fast genau auf den Wert $U_0$ ein. Der Widerstand 35 ist stromlos. Wenn R der sich einstellende Widerstand des Shunt-FET ist, so kann man mit Hilfe des Ohmschen Gesetzes den Widerstand angeben.

Es ist

$$R = \frac{U_0}{I_0}$$

$I_0$ ist der Gleichstromanteil im Foto-Strom. Bei kleinen Strömen $I_0$ ergeben sich große Widerstände R. Große Ströme $I_0$ ergeben kleine Widerstände R.

Wenn $R_E$ der Eingangswiderstand in den Empfänger 10 ist, stellt sich im Knoten 17 folgende Stromteilung ein:

$$I_E = \frac{R}{R + R_E} \cdot I$$

Der Eingang des Empfängers 10 wird entlastet. Für die Dimensionierung des Shunts von entscheidender Bedeutung sind die Wahl der Spannung $U_0$, des Widerstandes 35 und des Kondensators 34. Die folgende Tabelle gibt den Shuntwiderstand des FET für drei verschiedene Spannungen $U_0$ sowie für unterschiedliche Werte des Gleichstromanteiles $I_0$ des Stroms der Fotodiode wieder.

| Gleichstrom $I_0$ in pin Diode | $U_0$ 10 m V | $U_0$ 100 m V | $U_0$ 50 m V |
|---|---|---|---|
| 1 m A | 10 Ohm | 100 Ohm | 50 Ohm |
| 0,1 m A | 100 Ohm | 1 K Ohm | 500 Ohm |
| 10 u A | 1 K Ohm | 10 K Ohm | 5 K Ohm |
| 1 u A | 10 K Ohm | 100 K Ohm | 50 K Ohm |
| 0,1 u A | 100 K Ohm | 1 M Ohm | 500 K Ohm |

Bei dem mit 10 bezeichneten Empfänger handelt es sich in vielen Fällen um einen Transimpedanzverstärker, der den sehr hochohmigen Ausgang der Fotodiode 11 niederohmig abschließt.

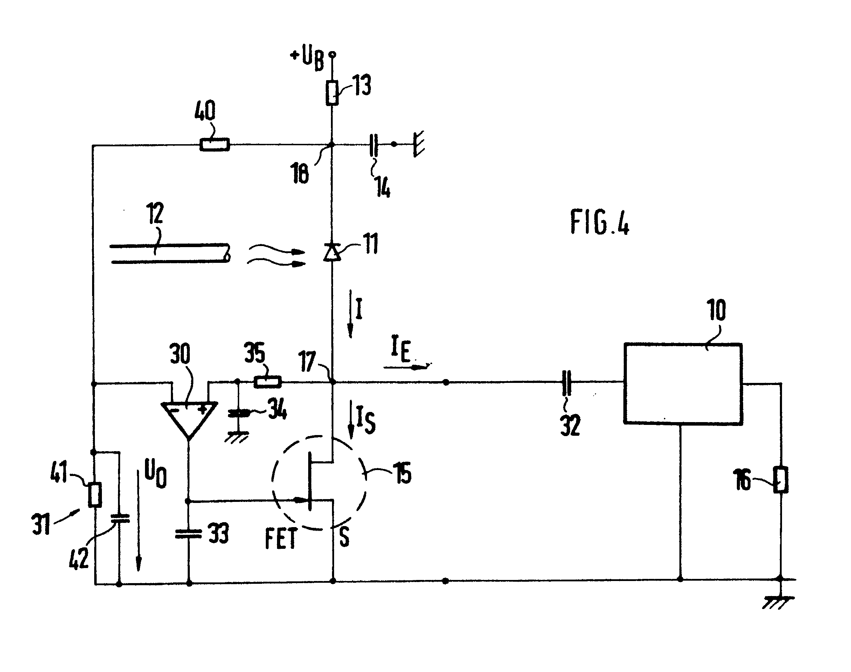

Fig. 4 zeigt eine Schaltungsvariante von Fig. 3, bei welcher die Spannungsquelle 31 mit der Spannung $U_0$ ersetzt wird durch einen aus den Widerständen 40 und 41 bestehenden Spannungsteiler. Kondensator 42 legt den invertierenden Eingang des Operationsverstärkers 30 hochfrequenzseitig auf Masse. Potentialänderungen am Punkt 18 werden auf den invertierenden Eingang des Operationsverstärkers 30 übertragen.

## Patentansprüche

1. Vorrichtung zum Empfang optischer Signale, mit einer Fotodiode (11), die ein von einem einfallenden optischen Signal abhängiges Ausgangssignal erzeugt, mit einem einen Eingang und einen Ausgang aufweisenden Empfänger (10), dessen Eingang mit der Fotodiode verbunden ist, weiterhin mit einer Regeleinrichtung, die einen dem Eingang des Empfängers parallel geschalteten steuerbaren Widerstand (15) beeinflußt,
**dadurch gekennzeichnet,** daß ein im Ausgangssignal der Fotodiode enthaltener Gleichstromwert als Eignangssignal der Regeleinrichtung dient.

2. Vorrichtung nach Anspruch 1, gekennzeichnet durch einen Feldeffekttransistor (FET) als steuerbaren Widerstand.

3. Vorrichtung nach Anspruch 2, mit einem einen invertierenden und einen nicht invertierenden Eingang sowie einen Ausgang aufweisenden Operationsverstärker (30) als Regeleinrichtung.

4. Vorrichtung nach Anspruch 3, dadurch gekennzeichnet, daß das Ausgangssignal der Fotodiode über einen hochohmigen Widerstand (35) mit dem nicht invertierenden Eingang des Operationsverstärkers (30) verbunden ist.

5. Vorrichtung nach Anspruch 3, dadurch gekennzeichnet, daß der invertierende Eingang des Operationsverstärkers auf festem aber frei wählbarem Potential liegt (bzw. vom Fotostrom mitgeführt wird).

6. Vorrichtung nach den Ansprüchen 3 bis 5, dadurch gekennzeichnet, daß der Ausgang des Operationsverstärkers mit dem Gateanschluß des FET verbunden ist.

7. Vorrichtung nach Anspruch 4, dadurch gekennzeichnet, daß der nicht invertierende Eingang des Operationsverstärkers über einen ersten Kondensator (34) mit dem Bezugspotential verbunden ist.

8. Vorrichtung nach Anspruch 1, dadurch gekennzeichnet, daß der Empfänger einen Transimpedanzverstärker enthält.

9. Vorrichtung nach Anspruch 2, dadurch gekennzeichnet, daß der FET als ohmscher Widerstand, d.h. im Anlaufbereich seines Kennlinienfeldes, arbeitet.

10. Vorrichtung nach Anspruch 3, dadurch gekennzeichnet, daß der Ausgang des Operationsverstärkers über einen zweiten Kondensator (33) mit dem Bezugspotential verbunden ist.

11. Vorrichtung nach Anspruch 1, dadurch gekennzeichnet, daß die Fotodiode über einen dritten Kondensator (33) mit dem Eingang des Empfängers verbunden ist.

FIG.1

FIG.2

FIG.3

EP 0 451 748 A2

FIG.4